(19) **Europäisches Patentamt / European Patent Office / Office européen des brevets**

(11) **EP 2 930 722 B1**

(12) **EUROPEAN PATENT SPECIFICATION**

(45) Date of publication and mention
of the grant of the patent:
**20.03.2019 Bulletin 2019/12**

(21) Application number: **13861241.1**

(22) Date of filing: **29.11.2013**

(51) Int Cl.:
*H01B 13/00* (2006.01)  *H01B 5/14* (2006.01)
*H05K 3/10* (2006.01)

(86) International application number:
**PCT/JP2013/082255**

(87) International publication number:
**WO 2014/087945 (12.06.2014 Gazette 2014/24)**

(54) **PROCESS FOR MANUFACTURING CONDUCTIVE FILM AND PRINTED WIRING BOARD**

VERFAHREN ZUR HERSTELLUNG EINES LEITFÄHIGEN FILMS UND EINER LEITERPLATTE

PROCESSUS DE FABRICATION D'UN FILM CONDUCTEUR ET CARTE À CÂBLAGE IMPRIMÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.12.2012 JP 2012267817**

(43) Date of publication of application:
**14.10.2015 Bulletin 2015/42**

(73) Proprietor: **FUJIFILM Corporation
Tokyo 106-8620 (JP)**

(72) Inventors:
• **USAMI Yoshihisa
Ashigara-kami-gun
Kanagawa 258-8577 (JP)**
• **OHTA Hiroshi
Ashigara-kami-gun
Kanagawa 258-8577 (JP)**

(74) Representative: **Hoffmann Eitle
Patent- und Rechtsanwälte PartmbB
Arabellastraße 30
81925 München (DE)**

(56) References cited:
JP-A- H0 537 126      JP-A- S6 433 084
JP-A- 2007 330 930    JP-A- 2010 528 428
JP-A- 2010 534 932    JP-A- 2011 047 021
JP-A- 2012 178 486    US-A1- 2006 189 113
US-A1- 2007 104 878   US-A1- 2008 085 410
US-A1- 2008 286 488

• **BONGCHUL KANG ET AL.: 'One-Step Fabrication
of Copper Electrode by Laser -Induced Direct
Local Reduction and Agglomeration of Copper
Oxide Nanoparticle' THE JOURNAL OF
PHYSICAL CHEMISTRY C vol. 115, no. ISSUE,
2011, pages 23664 - 23670, XP055201637**

**Description**

TECHNICAL FIELD

The present invention relates to a method for manufacturing a conductive film. Particularly, the present invention relates to a method for manufacturing a conductive film by means of irradiation with a continuous wave laser beam under predetermined conditions.

BACKGROUND ART

As a method for forming a metallic film on a substrate, a technique is known in which a substrate is coated with a dispersion of metal particles or metal oxide particles by a printing method, and the coated dispersion is sintered by being subjected to light irradiation processing such that an electrically conductive site such as a metallic film or wiring in a circuit board is formed.

Compared to the conventional wiring preparation method that is performed by high temperature/vacuum processing (sputtering) or plating processing, the aforementioned method is simple and saves energy and resources. Therefore, the method is regarded as a highly promising technique for the development of next-generation electronics.

For example, Patent Literature 1 discloses a method for depositing a film containing copper oxide nanoparticles on the surface of a substrate and exposing at least a portion of the film to light to make the exposed portion conductive.

Further, Patent Literature 2 discloses (particularly in Examples thereof) a method for forming a conductive pattern by irradiating a fine particle layer containing colloidal particles of a metal or composite metal with laser light under predetermined conditions (a linear velocity, an output, and the like).

CITATION LIST

PATENT LITERATURE

Patent Literature 1: JP 2010-528428 A
Patent Literature 2: JP 2004-143571 A

US 2007/104878 A1 relates to precursor compositions for the fabrication of electronic features such as resistors and capacitors. The precursor compositions are formulated to have a low conversion temperature, such as not greater than about 350° C., thereby enabling the fabrication of such electronic features on a variety of substrates, including organic substrates such as polymer substrates. US 2008/0286488 A1, US 2006/0189113 A1, US 2008/0085410 A1 and Kang et al., "One-Step fabrication of Copper Electrode by Laser-Induced Direct Local Reduction and Agglomeration of Copper Oxide Nanoparticle", J. Phys. Chem. C 2011, 115, 23664-23670, are further prior art.

SUMMARY OF INVENTION

TECHNICAL PROBLEMS

Meanwhile, in recent years, from the viewpoint of cost reduction, it has been required to develop a method for forming a conductive film which contains a metal having excellent conductive properties by using a composition containing metal oxide particles such as copper oxide particles.

Further, in recent years, in order to respond to the demand for miniaturization and performance improvement of electronic instruments, wiring in a printed wiring board or the like has been further miniaturized and integrated to a higher degree. Because of this, a further improvement of the adhesiveness between a substrate and a conductive film is also required.

Referring to Patent Literature 1 and Patent Literature 2, the present inventors manufactured a conductive film by scanning a layer containing metal oxide particles represented by copper oxide particles with a continuous wave laser beam in the form of a predetermined pattern. As a result, it was confirmed that under the conditions specifically disclosed in Patent Literature 2, reduction of the metal oxide particles does not proceed sufficiently, and in addition, the adhesiveness of the obtained layer with respect to a substrate deteriorates.

The present invention has been made in consideration of the aforementioned current circumstances, and an object thereof is to provide a method for manufacturing a conductive film capable of causing the reduction of metal oxide to metal to proceed efficiently and manufacturing a conductive film which exhibits excellent adhesiveness with respect to a substrate.

SOLUTION TO PROBLEMS

As a result of conducting intensive research to solve the problems of the prior art, the present inventors found that if the scanning condition, the irradiation condition, and the like of a continuous wave laser beam are controlled, the aforementioned problems can be solved.

That is, they found that the aforementioned object can be achieved by the following constitution.

(1) The invention is defined by claim 1.

(2) The method for manufacturing a conductive film according to (1), wherein the irradiation time is at least 2.0 $\mu$s.

(3) The method for manufacturing a conductive film according to (1) or (2), wherein the continuous wave laser beam has a wavelength not less than 2.0 $\mu$m.

(4) The method for manufacturing a conductive film according to any one of (1) to (3), wherein the substrate includes polyimide.

(5) The method for manufacturing a conductive film according to any one of (1) to (4), wherein the precursor film has a thickness not less than 10 $\mu$m.

(6) The method for manufacturing a conductive film according to any one of (1) to (5), wherein the particles of a metal oxide contains at least one metal element selected from the group consisting of Au, Ag, Cu, Pt, Pd, In, Ga, Sn, Ge, Sb, Pb, Zn, Bi, Fe, Ni, Co, Mn, Tl, Cr, V, Ru, Rh, Ir, Mo, W, Ti, and Al.

(7) A printed wiring board, comprising a conductive film manufactured by the method for manufacturing a conductive film according to any one of (1) to (6).

ADVANTAGEOUS EFFECTS OF INVENTION

According to the present invention, it is possible to provide a method for manufacturing a conductive film capable of causing the reduction of metal oxide to metal to proceed efficiently and manufacturing a conductive film which exhibits excellent adhesiveness with respect to a substrate.

BRIEF DESCRIPTION OF DRAWINGS

FIG. 1 is a schematic diagram showing an embodiment of an irradiation process.
FIG. 2 is a graph showing a preferred range of scanning speed and laser power.

DESCRIPTION OF EMBODIMENTS

Hereinafter, preferable embodiments of the method for manufacturing a conductive film of the present invention will be described in detail.

First, characteristics of the present invention compared to the conventional technique will be specifically described.

As described above, in the present invention, the irradiation conditions (a laser power and an irradiation condition) of a continuous wave laser beam and the scanning conditions of the continuous wave laser beam and an object to be irradiated are controlled. More specifically, a scanning speed, an irradiation time, and a laser power are controlled to values equal to or more than predetermined values. Mechanisms for obtaining the desired effects by controlling the conditions as described above can be explained as follows.

First, when a precursor film (an object to be irradiated) containing metal oxide particles is irradiated with a continuous wave laser beam, the reduction reaction of metal oxide to metal proceeds. However, when the precursor film is excessively irradiated with the continuous wave laser beam, the generated metal reverts to metal oxide. Presumably, the reason for this is that even though the reduction reaction of metal oxide to metal proceeds once by allowing the metal oxide to absorb the continuous wave laser beam, if a cooling speed is slow at the time of cooling, copper reverts to copper oxide. Therefore, by controlling the scanning speed and irradiation conditions, the reversion of copper to copper oxide is controlled so as not to proceed.

Further, by irradiating the precursor film with the continuous wave laser beam in an amount equal to or more than a predetermined irradiation amount, a part of the precursor film is heated and melted, and the precursor film and the substrate are mixed with each other around the interface therebetween, thereby forming an anchor structure between the conductive film manufactured and the substrate and improving the adhesiveness of the conductive film.

The method for manufacturing a conductive film according to a preferred embodiment of the present invention at least includes two processes of a process of forming a precursor film (precursor film forming process) and a process of irradiating the precursor film with a continuous wave laser beam (irradiation process).

Hereinafter, materials and procedures used in the respective processes will be described in detail.

[Precursor film forming process]

The precursor film forming process is a process of forming a precursor film containing metal oxide particles by applying a dispersion liquid containing the metal oxide particles onto a substrate. By carrying out this process, the precursor film to be irradiated with the continuous wave laser beam, which will be described later, is formed.

Hereinafter, first, materials used in this process will be described in detail, and then procedures of this process will be described in detail.

(Particles of metal oxide)

As particles of metal oxide (hereinafter, also referred to as "metal oxide particles"), the type thereof is not limited as long as they are particles of oxide containing a metal element. Especially, in terms of formation of a conductive film being excellent, the particles of metal oxide preferably contain at least one metal element selected from the group consisting of Au, Ag, Cu, Pt, Pd, In, Ga, Sn, Ge, Sb, Pb, Zn, Bi, Fe, Ni, Co, Mn, Tl, Cr, V, Ru, Rh, Ir, Mo, W, Ti, and Al, and more preferably contain at least one metal element selected from the group consisting of Au, Ag, Cu, Pt, Pd, In, Ga, Sn, Ge, Sb, Pb, Zn, Bi, Fe, Ni, and Co. Particularly, copper oxide particles are even more preferable, because they are easily reduced, and the metal generated therefrom is relatively stable.

Here, "copper oxide" refers to a compound which substantially does not contain copper that is not oxidized. Specifically, it refers to a compound from which a peak resulting from copper oxide is detected and from which a peak resulting from metallic copper is not detected in crystal analysis utilizing X-ray diffraction. The clause "substantially does not contain copper" means a state in which the content of copper is equal to or less than 1% by weight with respect to the copper oxide particles, though the present invention is not limited thereto.

As the copper oxide, copper (I) oxide or copper (II) oxide is preferable. Of these, copper (II) oxide is more preferable since it is available at a low cost and has low resistance.

The average particle size of the metal oxide particles is not particularly limited. However, it is preferably 200 nm or less, and more preferably 100 nm or less. The lower limit thereof is not also limited. However, it is preferably 10 nm or more.

If the average particle size is 10 nm or more, it is preferable since the activity of the particle surface does not become excessively high, and thus the particles exhibit excellent handleability. If the average particle size is 200 nm or less, it is preferable since a pattern such as wiring can be easily formed by a printing method using a solution containing the metal oxide particles as an ink for ink jet, and in addition, the metal oxide particles are sufficiently reduced to metal, and thus the obtained conductive film exhibits excellent conductivity.

The average particle size refers to the average primary particle size. For determining the average particle size, at least 50 metal oxide particles are observed with a transmission electron microscope (TEM) or a scanning electron microscope (SEM) so as to measure the particle sizes (diameters) thereof, and the arithmetic mean of the diameters is calculated to determine the average particle size. When the shape of the metal oxide particles in the observed image is not a perfect circle, the major axis of the particles is measured as the diameter.

(Dispersion liquid containing metal oxide particles)

The dispersion liquid contains the aforementioned metal oxide particles. If necessary, the dispersion liquid may contain a solvent. The solvent functions as a dispersion medium of the metal oxide particles.

The type of the solvent is not particularly limited, and for example, water, organic solvents such as alcohols, ethers, and esters, and the like can be used. Among these, water, an aliphatic alcohol having one to three hydroxy groups, an alkyl ether derived from the aliphatic alcohol, an alkyl ester derived from the aliphatic alcohol, or a mixture thereof is preferably used, since these solvents excellently disperse the metal oxide particles.

If necessary, other components (for example, binder resin, metal particles, or the like) may be contained in the dispersion liquid.

(Substrate)

As the substrate used in this process, a known material can be used. Examples of the material used as the substrate include a resin, paper, glass, a silicon-based semiconductor, a compound semiconductor, a metal oxide, a metal nitride, wood, and a composite material of these.

More specifically, examples thereof include resin substrates such as a low-density polyethylene resin, a high-density polyethylene resin, an ABS resin, an acrylic resin, a styrene resin, a vinyl chloride resin, a polyester resin (polyethylene terephthalate), a polyacetal resin, a polysulfone resin, a polyether imide resin, a polyether ketone resin, and cellulose derivatives; paper substrates such as non-coated printing paper, light-weight coated printing paper, coated printing paper (art paper and coat paper), special printing paper, copying paper (PPC paper), unbleached packaging paper (unglazed kraft paper for heavy-duty sacks and unglazed kraft paper), bleached packaging paper (bleached kraft paper and pure-white roll paper), coated cardboard, chipboard paper, and corrugated cardboard; glass substrates such as soda-lime glass, borosilicate glass, silica glass, and quartz glass; silicon-based semiconductor substrates such as amorphous silicon and polysilicon; compound semiconductor substrates such as CdS, CdTe, and GaAs; metal substrates such as a copper sheet, an iron sheet, and an aluminum sheet; other inorganic substrates such as alumina, sapphire, zirconia, titania, yttrium oxide, indium oxide, indium tin oxide (ITO), indium zinc oxide (IZO), Nesa (tin oxide), antimony-doped tin oxide (ATO), fluorine-doped tin oxide, zinc oxide, aluminum-doped zinc oxide (AZO), gallium-doped zinc oxide, an aluminum nitride substrate, and silicon carbide; and composite substrates such as paper-resin composite materials including paper-phenol resin, paper-epoxy resin and paper-polyester resin, and glass-resin composite materials including glass fabric-epoxy resin, glass fabric-polyimide resin and glass fabric-fluororesin. Among these, a polyester resin substrate, a polyether imide resin substrate, a paper substrate, and a glass substrate are preferably used.

Among these, the substrate is preferably a resin substrate containing at least one selected from the group consisting of, for instance, polyimide, polyethylene terephthalate, polycarbonate, cellulose ester, polyvinyl chloride, polyvinyl acetate, polyurethane, silicone, polyvinyl ethyl ether, polysulfide, polyolefin (polyethylene, polypropylene, and the like), and polyacrylate.

If such a resin substrate is used, the substrate hardly absorbs a laser beam (particularly, a laser beam having a wavelength of 2 $\mu$m or more, for example, a carbon gas laser), and thus the temperature of the substrate does not become high. Consequently, the quenching of the metal, which is generated by the reduction resulting from the absorption of the laser beam, efficiently proceeds, and thus it is possible to suppress the reversion of the metal to copper oxide.

(Procedures of process)

The method for applying the dispersion liquid onto the substrate is not particularly limited, and a known method can be adopted. Examples thereof include coating methods such as a screen printing method, a dip coating method, a spray coating method, a spin coating method, and an ink jet method.

The form of the dispersion liquid applied is not particularly limited. The dispersion liquid may be applied in the form of a plane covering the entire surface of the substrate or may be applied in the form of a pattern (for example, the form of wiring or the form of dots).

In the present process, if necessary, the dispersion liquid may be subjected to drying processing after being applied onto the substrate so as to remove the solvent. If the residual solvent is removed, it is possible to inhibit minute cracks or voids from being generated due to the evaporative expansion of the solvent in the irradiation process which will be described later, and thus, it is preferable in view of the conductivity of the conductive film and the adhesiveness between the conductive film and the substrate.

The drying processing can be performed by a method using a hot-air dryer. In the drying processing, heating processing is preferably performed at a temperature that does not cause reduction of the metal oxide particles, preferably performed at a temperature of 40°C to 200°C, more preferably performed at a temperature equal to or higher than 50°C but lower than 150°C, and even more preferably performed at a temperature of 70°C to 120°C.

(Precursor film)

The precursor film contains metal oxide particles, and is turned into a conductive film by the reduction of metal oxide particles to metal through light irradiation, which will be described later.

The precursor film contains metal oxide particles, and particularly, it is preferable that the precursor film contains metal oxide particles as a main component. Here, the term "main component" means that the weight of the metal oxide particles occupies 80 wt% or more of the total weight of the precursor film. The content of the metal oxide particles in the precursor film is preferably 85 wt% or more, and more preferably 90 wt% or more. The upper limit thereof is not particularly limited, and is exemplified by 100 wt%.

The precursor film may contain other components (for example, binder resin) in addition to the metal oxide particles.

The thickness of the precursor film is not particularly limited, and an optimum thickness is appropriately selected depending on the application of the conductive film to be formed. Especially, in view of better reduction efficiency of the metal oxide particles by light irradiation, which will be described later, the thickness thereof is preferably 0.5 $\mu$m to 2000

μm, more preferably 0.5 μm to 200 μm, even more preferably 1.0 μm to 100 μm, and particularly preferably 10 μm to 100 μm.

The precursor film may be provided on the entire surface of the substrate, or may be provided in the form of a pattern.

[Irradiation process]

The irradiation process is a process in which the precursor film obtained in the above process is irradiated with a continuous wave laser beam while relatively scanning the laser beam with respect to the precursor film, thereby reducing the metal oxide in the region of the precursor film irradiated with the laser beam and forming a conductive film containing metal. When the precursor film is irradiated with the continuous wave laser beam, the metal oxide absorbs light, and the reduction reaction of metal oxide to metal proceeds. The absorbed light is also converted into heat, and the generated heat penetrates into the inside of the precursor film, thereby the reduction reaction of metal oxide to metal proceeds even in the inside of the precursor film. In other words, by performing the above process, metal particles obtained by the reduction of the metal oxide particles are fused with each other to form grains, and further the grains are aggregated and fused with each other to form a conductive film.

Hereinafter, the irradiation process will be described in more detail with reference to the accompanying drawings.

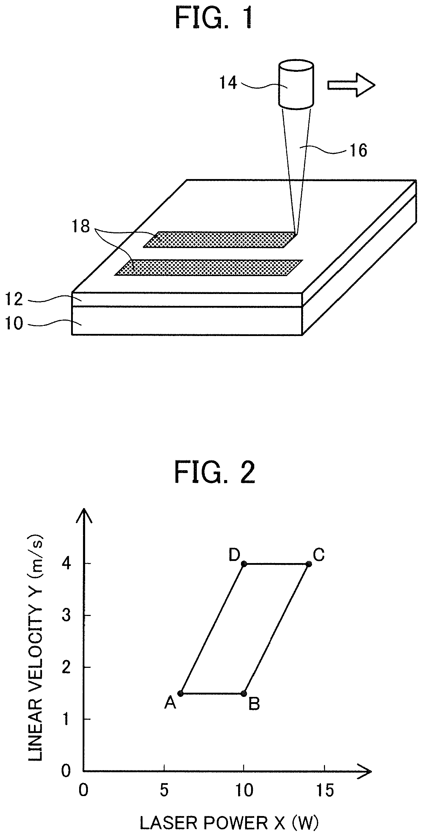

FIG. 1 shows an embodiment in which a precursor film 12 disposed on a substrate 10 is irradiated with a laser beam 16 from a laser beam source 14. In FIG. 1, the laser beam source 14 is moved in the direction of the arrow by a scanning mechanism (not shown), and irradiation is performed in a predetermined region of the precursor film 12 while scanning the surface thereof. In the region irradiated with the laser beam 16, the reduction reaction of metal oxide to metal proceeds, and a conductive film 18 containing metal is formed.

In FIG. 1, although the conductive film 18 is formed in the form of a linear pattern, the shape thereof is not limited to that shown in FIG. 1. For example, the conductive film may be formed in the form of a curved pattern, or the conductive film may be formed over the entire surface of the substrate.

As the irradiation apparatus for irradiating with a continuous wave laser beam, known irradiation apparatuses can be used. For example, an ML-Z9500 series apparatus of KEYENCE Corporation and the like can be used.

In FIG. 1, an embodiment in which the laser beam source 14 is moved by a scanning mechanism is shown. However, the present invention is not limited to this embodiment, and the laser beam has only to relatively scan the precursor film as an object to be irradiated. In an exemplary method, a substrate provided with the precursor film as an object to be irradiated is mounted on an X-Y axis stage which is movable in a horizontal direction with respect to a scanning plane, and the stage is moved in a state where the laser beam is fixed, thereby scanning the surface of the precursor film with the laser beam. Needless to say, an embodiment in which both of the laser beam and the precursor film as an object to be irradiated are moved may be adopted.

The wavelength of the continuous wave laser beam is not particularly limited as long as it is a wavelength which can be absorbed by metal oxide particles. As the wavelength thereof, any wavelength can be selected from a range of ultraviolet light to infrared light. Especially, the wavelength of the continuous wave laser beam is preferably 2.0 μm or more, more preferably 3.0 μm or more, even more preferably 5.0 μm or more, and particularly preferably 9.0 μm or more. If the wavelength is within the above range, the reduction of the metal oxide particles proceeds more easily. The upper limit of the wavelength is not particularly limited. In general, however, it is preferably 30 μm or less from the viewpoint of the performance of the irradiation apparatus.

Typical examples of the laser include a semiconductor laser such as AlGaAs-based laser, InGaAsP-based laser, GaN-based laser, and the like; a Nd:YAG laser; an excimer laser such as ArF laser, KrF laser, XeCl laser, and the like; a dye laser; a solid-state laser such as a ruby laser; a gas laser such as He-Ne laser, He-Xe laser, He-Cd laser, CO2 laser, Ar laser, and the like; and a free electron laser. Among these, CO2 laser (carbon dioxide laser) is preferable.

In the irradiation process, the scanning speed is 1.0 m/s or more, and from the viewpoints that the reduction of metal oxide to metal in the precursor film proceeds more efficiently, and the productivity of the conductive film is more improved, the scanning speed is preferably 1.5 m/s or more, more preferably 2.0 m/s or more, and even more preferably 3.0 m/s or more. The upper limit of the scanning speed is not particularly limited. However, generally, it is often 100 m/s or less, and more often 50 m/s or less, from the viewpoint of the performance of the irradiation apparatus.

When the scanning speed is less than 1.0 m/s, the conversion of metal oxide into metal in the precursor film does not sufficiently proceed (because metal reverts to metal oxide), and consequently, a conductive film having poor conductive properties is obtained.

In the irradiation process, the laser power of the continuous wave laser beam is 6.0 W or more, and from the viewpoints that the reduction of metal oxide to metal in the precursor film proceeds more efficiently, and the adhesiveness of the conductive film is more improved, the laser power thereof is preferably 7.0 W or more, and more preferably 8.0 W or more. The upper limit of the laser power is not particularly limited. However, it is 1 kW or less, more preferably 500 W or less, even more preferably 100 W or less, particularly preferably 16.0 W or less, and most preferably 14.0 W or less, from the viewpoint that the evaporation of the material itself is more suppressed.

When the laser power of the continuous wave laser beam is less than 6.0 W, the reduction of metal oxide to metal in the precursor film does not sufficiently proceed, or the adhesiveness of the conductive film is poor.

In the irradiation process, the irradiation time per spot on the precursor film surface is 1.0 µs or more, and from the viewpoints that the reduction of metal oxide to metal in the precursor film proceeds more efficiently, and the adhesiveness of the conductive film is more improved, the irradiation time is preferably 2.0 µs or more, more preferably 3.0 µs or more, and even more preferably 4.0 µs or more. The upper limit of the irradiation time is not particularly limited. However, it is 1000 µs or less, more preferably 500 µs or less, and even more preferably 100 µs or less. When the irradiation time is too long, the control of the irradiation becomes difficult, and the material itself is evaporated in some cases.

Here, the irradiation time means the time for which the continuous wave laser beam is to be applied to any spot on the precursor film surface irradiated with the continuous wave laser beam. The irradiation time can be calculated from the scanning speed and the beam diameter. For example, when the diametrical width of the continuous wave laser beam applied onto the surface of the precursor film is 60 µm as measured in a scanning direction and the scanning speed thereof is 2 m/s, the irradiation time is calculated to be 30 µs.

As a preferable embodiment of irradiation conditions in the irradiation process, in the two-dimensional coordinate system in which the laser power X of the continuous wave laser beam is set to a horizontal axis and the scanning speed Y of the continuous wave laser beam is set to a vertical axis, it is preferable that the laser power X and the scanning speed Y fall within a range defined by straight lines expressed by the following formulae (1) to (4). When the laser power X and the scanning speed Y fall within the following range, the reduction of metal oxide to metal proceeds more efficiently, and the adhesiveness of the obtained conductive film is more improved.

$$\text{Formula (1)} \quad Y = 1.5$$

$$\text{Formula (2)} \quad X = 14.0$$

$$\text{Formula (3)} \quad Y = 0.625X - 2.25$$

$$\text{Formula (4)} \quad Y = 0.625X - 4.75$$

Especially, from the viewpoints that the reduction of metal oxide to metal in the precursor film proceeds more efficiently, and the adhesiveness of the obtained conductive film is more improved, it is preferable that the laser power X and the scanning speed Y fall within a range defined by straight lines expressed by the following formulae (1) and (3) to (5).

$$\text{Formula (1)} \quad Y = 1.5$$

$$\text{Formula (3)} \quad Y = 0.625X - 2.25$$

$$\text{Formula (4)} \quad Y = 0.625X - 4.75$$

$$\text{Formula (5)} \quad Y = 4.0$$

FIG. 2 shows the range defined by straight lines expressed by the above formulae (1) and (3) to (5). In the two-dimensional coordinate system of FIG. 2, point A is (X = 6.0, Y = 1.5), point B is (X = 10.0, Y = 1.5), point C is (X = 14.0, Y = 4.0), and point D is (X = 10.0, Y = 4.0).

The beam diameter of the continuous wave laser beam applied onto the surface of the precursor film is not particularly limited, and is appropriately adjusted depending on the width of the conductive film to be formed. For example, when the conductive film is used as wiring of a printed wiring board, in terms of allowing thin wiring, the beam diameter

is preferably 5 μm to 1000 μm, more preferably 9 μm to 500 μm, and even more preferably 20 μm to 200 μm.

The atmosphere for carrying out the light irradiation processing is not particularly limited, and examples of the atmosphere include an air atmosphere, an inert atmosphere, a reducing atmosphere, and the like. Here, the inert atmosphere refers to an atmosphere filled with inert gas such as argon, helium, neon, nitrogen, and the like, and the reducing atmosphere refers to an atmosphere containing reducing gas such as hydrogen, carbon monoxide, and the like.

(Conductive film)

By performing the aforementioned process, a conductive film containing metal (metallic film) is obtained. For example, when copper oxide particles are used as the metal oxide particles, a conductive film containing metallic copper is obtained.

The film thickness of the conductive film is not particularly limited and can be appropriately adjusted to an optimal film thickness according to the use thereof. Particularly, if the conductive film is used for a printed wiring board, the film thickness is preferably 0.01 μm to 1000 μm, and more preferably 0.1 μm to 100 μm.

The film thickness is a value (average) obtained by measuring thicknesses at three or more random sites in the conductive film and calculating the arithmetic mean of the thicknesses.

In view of conductivity, the volume resistivity of the conductive film is preferably equal to or less than $1 \times 10^{-4}$ Ωcm, and more preferably equal to or less than $1 \times 10^{-5}$ Ωcm.

The volume resistivity can be calculated by measuring the value of surface resistance of the conductive film by a four-point probe method and then multiplying the obtained value of surface resistance by the film thickness.

The conductive film may be formed on the entire surface of the substrate, or may be formed in the form of a pattern on the substrate. The conductive film in the form of a pattern is useful as conductor interconnection (wiring) of a printed wiring board and the like.

Examples of the method for obtaining the conductive film in the form of a pattern include a method of applying the aforementioned dispersion liquid onto the substrate in a patterned manner and performing the aforementioned continuous wave laser beam irradiation processing, a method of etching the conductive film formed on the entire surface of the substrate in the form of a pattern, a method of irradiating the precursor film formed on the entire surface of the substrate with the continuous wave laser beam in the form of a pattern, and the like.

The etching method is not particularly limited, and a known method such as subtractive method, semi-additive method, and the like can be adopted.

When a conductive film is provided in the form of a pattern, if necessary, the non-irradiation region of the precursor film, onto which the continuous wave laser beam has not been applied, may be removed. The method of removing the non-irradiation region is not particularly limited, and examples thereof include a method of etching the non-irradiation region away using an etching solution such as an acid.

When the conductive film in the form of a pattern is constituted as a printed wiring board, an insulating layer (an insulating resin layer, an interlayer insulating film, or a solder resist) may be laminated on the surface of the conductive film in the form of a pattern, and wiring (a metallic pattern) may be further formed on the surface of the insulating layer.

The material of the insulating film is not particularly limited, and examples thereof include an epoxy resin, an aramid resin, a crystalline polyolefin resin, an amorphous polyolefin resin, a fluorine-containing resin (polytetrafluoroethylene, fully fluorinated polyimide, a fully fluorinated amorphous resin, or the like), a polyimide resin, a polyether sulfone resin, a polyphenylene sulfide resin, a polyether ether ketone resin, a liquid crystal resin, and the like.

Among these, from the viewpoint of adhesiveness, dimensional stability, heat resistance, electrical insulating properties, and the like, the insulating film preferably contains an epoxy resin, a polyimide resin, or a liquid crystal resin, and more preferably contains an epoxy resin. Specific examples of the epoxy resin-containing insulating film include ABF-GX13 manufactured by Ajinomoto Fine-Techno Co., Inc.

The solder resist, which is one of the materials of the insulating layer used for protecting wiring, is specifically described in JP 10-204150 A, JP 2003-222993 A, and the like, and the materials described in these documents can also be applied to the present invention as desired. As the solder resist, commercially available products may be used, and specific examples thereof include PFR 800 and PSR 4000 (trade names) manufactured by TAIYO INK MFG, CO., LTD., SR 7200G manufactured by Hitachi Chemical Co., Ltd., and the like.

The substrate having the conductive film obtained in the aforementioned manner (the substrate with the conductive film) is versatile. For example, such a substrate can be used for a printed wiring board, TFT, FPC, RFID, and the like.

EXAMPLES

Hereinafter, the present invention will be described in more detail based on Examples, but the present invention is not limited thereto.

<Example 1>

Copper oxide ink (ICI-020), manufactured by Novacentrix Corporation, was applied onto a polyimide substrate (thickness: 125 μm) using a bar coater to form a coating film, and then the substrate having the coating film was mounted on a hot plate and dried at 100°C for 10 minutes to remove a solvent. Thus, a substrate with a precursor film (precursor film thickness: 50 μm) was manufactured.

Subsequently, using ML-Z9550T manufactured by KEYENCE Corporation, the surface of the precursor film was scanned with a carbon dioxide laser (wavelength: 9.3 μm) having a beam-diametrical width of 60 μm in a scanning direction, with a pitch of 60 μm to manufacture a conductive film of line/space = 60 μm/60 μm. The laser power, scanning speed, and irradiation time used are summarized in Table 1.

(Evaluation of conductivity)

Conductivity was determined as the volume resistivity (Ω·cm) measured and calculated by a four-point probe method. Specifically, the volume resistivity of the conductive film was measured by directly measuring the thickness of the conductive film after baking from a cross section thereof using SEM (electron microscope S800, manufactured by Hitachi, Ltd.), and then inputting the measured thickness of the conductive film to a resistivity meter (Loresta, manufactured by Mitsubishi Chemical Corporation) utilizing a four-point probe method.

When the volume resistivity was $10^{-4}$ Ω·cm or less, it was represented as "A", and when the volume resistivity was more than $10^{-4}$ Ω·cm, it was represented as "B".

(Evaluation of adhesiveness)

In the obtained substrate with a conductive film, by using a cutter knife, 11 by 11 incisions were made in the form of a grid in the surface of the conductive film to cut a total of 100 squares. Then, a polyester adhesive tape "NO. 31B", manufactured by Nitto Denko Corporation, was stuck on the surface of the conductive film to perform an adhesiveness test. In the adhesiveness test, whether or not the conductive film was peeled off was visually observed. When the conductive film was not peeled off, it was represented as "A", and when the conductive film was peeled off, it was represented as "B".

<Examples 1 to 6 and Comparative Examples 1 to 5>

Conductive films were manufactured by changing the laser power, the scanning speed, and the irradiation time according to the description of Table 1. Each of the obtained conductive films was evaluated in the same manner as in Example 1. The results thereof are summarized in Table 1.

[Table 1]

Table 1

| | Scanning speed (m/s) | Laser power (W) | Irradiation time (μs) | Conductivity evaluation | Adhesiveness evaluation |
|---|---|---|---|---|---|
| Ex. 1 | 1.5 | 6.0 | 40 | A | A |
| Ex. 2 | 2.0 | 8.0 | 30 | A | A |
| Ex. 3 | 3.0 | 10.0 | 20 | A | A |
| Ex. 4 | 4.0 | 10.0 | 15 | A | A |
| Ex. 5 | 4.0 | 12.0 | 15 | A | A |
| Ex. 6 | 4.0 | 14.0 | 15 | A | A |
| Comp. Ex. 1 | 0.5 | 6.0 | 120 | B | A |
| Comp. Ex. 2 | 0.5 | 12.0 | 120 | B | A |

(continued)

|  | Scanning speed (m/s) | Laser power (W) | Irradiation time (μs) | Conductivity evaluation | Adhesiveness evaluation |
|---|---|---|---|---|---|
| Comp. Ex. 3 | 0.5 | 16.0 | 120 | B | A |
| Comp. Ex. 4 | 2.0 | 4.0 | 30 | B | B |
| Comp. Ex. 5 | 4.0 | 4.0 | 15 | B | B |

As shown in Table 1, in Examples 1 to 6 in each of which the method for manufacturing a conductive film according to the present invention was used, conductive films having excellent conductivity and adhesiveness were manufactured.

In contrast, when the scanning speed is slow as shown in Comparative Examples 1 to 3, or when the laser power is low as shown in Comparative Examples 4 and 5, desired effects were not obtained.

REFERENCE SIGNS LIST

10:     SUBSTRATE
12:     PRECURSOR FILM
14:     LASER BEAM SOURCE
16:     LASER BEAM
18:     CONDUCTIVE FILM

**Claims**

1. A method for manufacturing a conductive film (18), comprising the steps of:

    forming a precursor film (12) containing particles of a metal oxide by applying a dispersion liquid containing the particles onto a substrate (10); and
    irradiating the precursor film (12) with a continuous wave laser beam (16) under relative scanning of the precursor film (12) and the continuous wave laser beam (16), so as to reduce the metal oxide and thus form a metal-containing conductive film (18) in a region irradiated with the continuous wave laser beam (16),

    wherein:

    the relative scanning is carried out at a speed not less than 1.0 m/s;
    the continuous wave laser beam (16) has a laser power not less than 6.0 W and no greater than 1 kW; and
    the precursor film (12) is irradiated at an irradiation time per spot on its surface of not less than 1.0 μs and 1000 μs or less.

2. The method for manufacturing a conductive film according to claim 1, wherein the irradiation time is at least 2.0 μs.

3. The method for manufacturing a conductive film according to claim 1 or 2, wherein the continuous wave laser beam (16) has a wavelength not less than 2.0 μm.

4. The method for manufacturing a conductive film according to any one of claims 1 to 3, wherein the substrate (10) includes polyimide.

5. The method for manufacturing a conductive film according to any one of claims 1 to 4, wherein the precursor film (12) has a thickness not less than 10 μm.

6. The method for manufacturing a conductive film according to any one of claims 1 to 5, wherein the particles of a metal oxide contains at least one metal element selected from the group consisting of Au, Ag, Cu, Pt, Pd, In, Ga, Sn, Ge, Sb, Pb, Zn, Bi, Fe, Ni, Co, Mn, Tl, Cr, V, Ru, Rh, Ir, Mo, W, Ti, and Al.

7. A printed wiring board, comprising a conductive film (18) manufactured by the method for manufacturing a conductive film (18) according to any one of claims 1 to 6.

**Patentansprüche**

1. Verfahren zur Herstellung eines leitfähigen Films (18), umfassend die Schritte eines:

Bildens eines Vorläuferfilms (12), der Partikel eines Metalloxids enthält, durch Auftragen einer Dispersionsflüssigkeit, die die Partikel enthält, auf ein Substrat (10); und
Bestrahlens des Vorläuferfilms (12) mit einem Dauerstrichlaserstrahl (16) unter relativem Bewegen des Vorläuferfilms (12) und des Dauerstrichlaserstrahls (16), um das Metalloxid zu reduzieren und somit einen metallhaltigen leitfähigen Film (18) in einem Bereich, der mit dem Dauerstrichlaserstrahl (16) bestrahlt wird, zu bilden,

wobei:

das relative Bewegen bei einer Geschwindigkeit von nicht unter 1,0 m/s ausgeführt wird;
der Dauerstrichlaserstrahl (16) eine Laserleistung von nicht weniger als 6,0 W und nicht mehr als 1 kW aufweist; und
der Vorläuferfilm (12) mit einer Bestrahlungszeit pro Punkt auf seiner Oberfläche von nicht weniger als 1,0 $\mu$s und 1000 $\mu$s oder weniger bestrahlt wird.

2. Verfahren zur Herstellung eines leitfähigen Films nach Anspruch 1, wobei die Bestrahlungszeit zumindest 2,0 $\mu$s beträgt.

3. Verfahren zur Herstellung eines leitfähigen Films nach Anspruch 1 oder 2, wobei der Dauerstrichlaserstrahl (16) eine Wellenlänge von nicht weniger als 2,0 $\mu$m aufweist.

4. Verfahren zur Herstellung eines leitfähigen Films nach einem der Ansprüche 1 bis 3, wobei das Substrat (10) Polyimid beinhaltet.

5. Verfahren zur Herstellung eines leitfähigen Films nach einem der Ansprüche 1 bis 4, wobei der Vorläuferfilm (12) eine Dicke von nicht weniger als 10 $\mu$m aufweist.

6. Verfahren zur Herstellung eines leitfähigen Films nach einem der Ansprüche 1 bis 5, wobei die Partikel eines Metalloxids zumindest ein Metallelement, ausgewählt aus der Gruppe, bestehend aus Au, Ag, Cu, Pt, Pd, In, Ga, Sn, Ge, Sb, Pb, Zn, Bi, Fe, Ni, Co, Mn, Tl, Cr, V, Ru, Rh, Ir, Mo, W, Ti und Al, enthält.

7. Leiterplatte, umfassend einen leitfähigen Film (18), der durch das Verfahren zur Herstellung eines leitfähigen Films (18) nach einem der Ansprüche 1 bis 6 hergestellt ist.

**Revendications**

1. Procédé pour fabriquer un film conducteur (18), comprenant les étapes de :

formation d'un film de précurseur (12) contenant des particules d'un oxyde métallique en appliquant un liquide de dispersion contenant les particules sur un substrat (10) ; et
irradiation du film de précurseur (12) avec un faisceau laser à ondes continues (16) sous un balayage relatif du film de précurseur (12) et du faisceau laser à ondes continues (16), afin de réduire l'oxyde métallique et former ainsi un film conducteur contenant du métal (18) dans une région irradiée par le faisceau laser à ondes continues (16),

dans lequel :

le balayage relatif est effectué à une vitesse non inférieure à 1,0 m/s ;

le faisceau laser à ondes continues (16) a une puissance laser non inférieure à 6,0 W et non supérieure à 1 kW ; et

le film de précurseur (12) est irradié à un temps d'irradiation par point sur sa surface non inférieur à 1,0 $\mu$s et de 1000 $\mu$s ou moins.

2. Procédé pour fabriquer un film conducteur selon la revendication 1, dans lequel le temps d'irradiation est d'au moins 2,0 $\mu$s.

3. Procédé pour fabriquer un film conducteur selon la revendication 1 ou 2, dans lequel le faisceau laser à ondes continues (16) a une longueur d'onde non inférieure à 2,0 $\mu$m.

4. Procédé pour fabriquer un film conducteur selon l'une quelconque des revendications 1 à 3, dans lequel le substrat (10) inclut du polyimide.

5. Procédé pour fabriquer un film conducteur selon l'une quelconque des revendications 1 à 4, dans lequel le film de précurseur (12) a une épaisseur non inférieure à 10 $\mu$m.

6. Procédé pour fabriquer un film conducteur selon l'une quelconque des revendications 1 à 5, dans lequel les particules d'un oxyde métallique contiennent au moins un élément métallique sélectionné dans le groupe constitué par Au, Ag, Cu, Pt, Pd, In, Ga, Sn, Ge, Sb, Pb, Zn, Bi, Fe, Ni, Co, Mn, Tl, Cr, V, Ru, Rh, Ir, Mo, W, Ti et Al.

7. Carte de câblage imprimée, comprenant un film conducteur (18) fabriqué par le procédé pour fabriquer un film conducteur (18) selon l'une quelconque des revendications 1 à 6.

# FIG. 1

# FIG. 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010528428 A
- JP 2004143571 A
- US 2007104878 A1
- US 20080286488 A1
- US 20060189113 A1
- US 20080085410 A1
- JP 10204150 A
- JP 2003222993 A

**Non-patent literature cited in the description**

- **KANG et al.** One-Step fabrication of Copper Electrode by Laser-Induced Direct Local Reduction and Agglomeration of Copper Oxide Nanoparticle. *J. Phys. Chem. C,* 2011, vol. 115, 23664-23670